# EUROPEAN PATENT APPLICATION

(11) **EP 4 813 956 A1**
(43) Date of publication of application: **30.09.2026**
(21) Application number: 24894084.3
(22) Date of filing: 15.11.2024
(51) Int. Cl.: C04B 35/587, H01L 23/15

(54) **SILICON NITRIDE-BASED SINTERED COMPACT AND SILICON NITRIDE-BASED HEAT DISSIPATION SUBSTRATE**

(30) Priority: 22.11.2023 JP 2023197830
(71) Applicant: Niterra Co., Ltd., Nagoya-shi, Aichi 461-0005 (JP)
(72) Inventor: MOTEKI, Jun, Nagoya-shi, Aichi 461-0005 (JP); IHARA, Akio, Nagoya-shi, Aichi 461-0005 (JP); IKAI, Yoshihito, Nagoya-shi, Aichi 461-0005 (JP); KONDO, Akihiko, Nagoya-shi, Aichi 461-0005 (JP)
(74) Representative: Grünecker Patent- und Rechtsanwälte PartG mbB
(86) International application number: PCT/JP2024/040565
(87) International publication number: WO 2025/110093

(57) **Abstract**

To provide a silicon nitride-based sintered body and a silicon nitride-based heat radiation substrate which exhibit further higher mechanical strength, while high thermal conductivity is maintained. The silicon nitride-based sintered body mainly contains silicon nitride-based grains and a grain boundary phase surrounding the silicon nitride-based grains. The sintered body at least contains a rare earth element in a total amount of 1.0 to 7.5 wt%, an alkali metal element and an alkaline earth metal element in a total amount of 0.25 to 2.0 wt%, one or more elements selected from among Fe, Ni, Co, and Al in a total amount of 0.010 to 0.30 wt%, and a group 4 element in a total amount of 0.30 to 3.0 wt%. At least a part of the group 4 element forms one or more compounds each containing at least one of nitrogen and carbon, and the sintered body contains the compounds in a total amount of 0.30 to 3.0 wt%.

## Description

### TECHNICAL FIELD

The present invention relates to a silicon nitride-based sintered body and to a silicon nitride-based heat radiation substrate.

### BACKGROUND ART

Silicon nitride, having high thermal conductivity and mechanical strength, attracts attention as a material for electrically insulating heat radiation substrates of power modules for inverters installed in electric vehicles (EVs) and hybrid vehicles (HVs). Conventionally, aluminum nitride has been widely used as a material of electrically insulating heat radiation substrates. However, in the case of a power module for large current such as that for EVs, the temperature of the power module rises to about 250°C, and a large thermal stress is generated in its substrate due to the difference in thermal expansion between the substrate and a metal such as copper bonded thereto. As a result, the substrate formed of aluminum nitride having low mechanical strength is cracked or broken. Therefore, silicon nitride, which among general insulating ceramic materials is high in thermal conductivity and has higher mechanical strength, has been employed in an increasing number of cases, although the thermal conductivity of silicon nitride is lower than that of aluminum nitride.

Patent Document 1 discloses a silicon nitride sintered body which is substantially formed of silicon nitride and which has an aluminum content and an oxygen content of each 3.5 wt% or less, aluminum and oxygen being present as impurities, a density of 3.15 g/cm³ or higher, and a thermal conductivity of 40 W/mK or higher.

Patent Document 2 discloses a silicon nitride sintered body characterized by containing silicon nitride grains which has shorter axis diameter of 2 µm or more and a sum of the oxygen, Al, Ca, and Fe contents of 1,500 ppm or less; and a silicon nitride sintered body production method which includes molding raw material powder obtained by adding one or more oxides of yttrium and/or a lanthanoid group element to a silicon nitride powder, and sintering the molded product, wherein the silicon nitride powder employed in the production method has an Al content of 300 ppm or less and an oxygen content of 1 wt% or less and an α-phase conversion ratio of 70% or less.

### PRIOR ART DOCUMENTS

### PATENT DOCUMENTS

Patent Document 1: JPH04-175268A
Patent Document 2: JP2001-19557A

### SUMMARY OF THE INVENTION

### PROBLEM TO BE SOLVED BY THE INVENTION

The silicon nitride sintered body disclosed in Patent Document 1 is a silicon nitride sintered body having a thermal conductivity of 50 W/mK, corresponding to a high thermal conductivity among conventional insulating ceramics. However, the value of mechanical strength, which is an important factor for a heat radiation substrate, is not demonstrated. Also, the sintered body is produced through industrially high-load steps involving a firing temperature of 2,000°C, a maintaining time of 20 hr, and press force of 200 kg/cm², which is also problematic.

The production method disclosed in Patent Document 2 aims at enhancement of the thermal conductivity of a substrate by reducing the impurity content of a material thereof. However, a relatively long-term firing process (at 1,900°C for 8 to 48 hours) is required for sintering, and grain growth easily occurs. Thus, residual pores remain, resulting in a relatively low mechanical strength.

Under such circumstances, when a silicon nitride sintered body is used as an insulating heat radiation substrate of a power device, there has been a demand for further enhancement of mechanical strength in order to enhance reliability of a substrate, while high thermal conductivity is maintained.

The present invention has been conceived to meet the demand. Thus, an object of the invention is to provide a silicon nitride-based sintered body and a silicon nitride-based heat radiation substrate which exhibit further higher mechanical strength, while high thermal conductivity is maintained.

### MEANS FOR SOLVING THE PROBLEMS

(1) In order to attain the aforementioned object, the present invention provides a silicon nitride-based sintered body with the following technical means. Accordingly, an application example of the silicon nitride-based sintered body of the present invention is directed to a silicon nitride-based sintered body mainly comprising silicon nitride-based grains and a grain boundary phase surrounding the silicon nitride-based grains, wherein the sintered body at least contains a rare earth element in a total amount of 1.0 to 7.5 wt%, an alkali metal element and an alkaline earth metal element in a total amount of 0.25 to 2.0 wt%, one or more elements selected from among Fe, Ni, Co, and Al in a total amount of 0.010 to 0.30 wt%, and a group 4 element in a total amount of 0.30 to 3.0 wt%; at least a part of the group 4 element forms one or more compounds each containing at least one of nitrogen and carbon; and the sintered body contains the compounds in a total amount of 0.30 to 3.0 wt%.
(2) In the silicon nitride-based sintered body according to the application example (1) above, the compound or compounds have an average grain size of 8.0 µm or less.
(3) In the silicon nitride-based sintered body according to the application example (1) or (2) above, the number of grains linking to one another in the compound or compounds is smaller than 3.
(4) In the silicon nitride-based sintered body according to the application examples of any of (1) to (3) above, the group 4 element includes one or more elements selected from Zr and Hf.
(5) An application example of the silicon nitride-based heat radiation substrate of the present invention is formed of a silicon nitride-based sintered body according to any of (1) to (4) above.
(6) In the silicon nitride-based heat radiation substrate according to the application example (5) above, a flexural strength is 650 MPa or higher.
(7) In the silicon nitride-based heat radiation substrate according to the application example (5) or (6) above, a thermal conductivity is 85 W/mK or higher.
(8) In the silicon nitride-based heat radiation substrate according to any of the application examples (5) to (7) above, a thickness in a direction perpendicular to its one main face is 220 µm or more and 690 µm or less.

### EFFECTS OF THE INVENTION

According to the silicon nitride-based sintered body or the silicon nitride-based heat radiation substrate of the present invention, there can be provided a silicon nitride-based sintered body or a silicon nitride-based heat radiation substrate which exhibits a further high mechanical strength, while high thermal conductivity is maintained.

### BRIEF DESCRIPTION OF THE DRAWINGS

[FIG. 1] A schematic perspective view showing an example of a silicon nitride-based heat radiation substrate according to an embodiment of the present invention.
[FIG. 2] A schematic cross-sectional view showing an example of a power device employing the silicon nitride-based heat radiation substrate according to an embodiment of the present invention.
[FIG. 3] A table showing the element contents and characteristics of the grain boundary phase of each sample.
[FIG. 4] A table showing the element contents and characteristics of the grain boundary phase of each sample.
[FIG. 5] A table showing properties of each sample.

### MODES FOR CARRYING OUT THE INVENTION

Embodiments of the present invention will now be described with reference to the drawings. In order to facilitate understanding of description, identical constituent elements in the drawings are denoted by the same reference numerals, and their redundant descriptions are omitted. Notably, in structural views, the sizes of constituent elements are conceptually represented and do not necessarily represent the actual dimensional ratios.

### [Embodiments]

### [structure of silicon nitride-based sintered body]

Firstly, an embodiment of the silicon nitride-based sintered body of the present invention will be described. The silicon nitride-based sintered body according to the embodiment of the present invention is a silicon nitride-based sintered body mainly comprising silicon nitride-based grains and a grain boundary phase surrounding the silicon nitride-based grains. The term "silicon nitride-based grains" refers to silicon nitride grains or Sialon grains. However, since Sialon provides a lower thermal conductivity as compared with silicon nitride, the amount of Sialon is preferably adjusted to that generated within a range of the below-mentioned Al content as the upper limit. The expression "mainly comprising silicon nitride-based grains and a grain boundary phase surrounding the silicon nitride-based grains" allows presence of an impurity other than the below-mentioned elements of 0.5 wt% or less.

The silicon nitride-based sintered body contains a rare earth element in a total amount of 1.0 to 7.5 wt%. When the rare earth element content is lower than the lower limit of the range, sinterability decreases, and pores remain, whereby the mechanical strength of the silicon nitride-based sintered body may decrease in some cases. When the rare earth element content is higher than the upper limit of the range, the grain boundary phase content increases, whereby the thermal conductivity of the silicon nitride-based sintered body may decrease in some cases. Regardless of the species of the rare earth element, the same effects are conceivably attained. Examples of the rare earth element which may be employed include yttrium (Y), lanthanum (La), erbium (Er), and ytterbium (Yb).

The silicon nitride-based sintered body contains an alkali metal element and an alkaline earth metal element in a total amount of 0.25 to 2.0 wt%. When the total amount of the alkali metal element and the alkaline earth metal element is lower than the lower limit of the range, the mechanical strength of the silicon nitride-based sintered body may decrease in some cases. When the total amount of the alkali metal element and the alkaline earth metal element is higher than the upper limit of the range, the thermal conductivity of the silicon nitride-based sintered body may decrease in some cases.

The silicon nitride-based sintered body contains one or more elements selected from among Fe, Ni, Co, and Al in a total amount of 0.010 to 0.30 wt%. When the total amount of one or more elements selected from among Fe, Ni, Co, and Al is lower than the lower limit of the range, sinterability decreases, and pores remain, whereby the mechanical strength of the silicon nitride-based sintered body may decrease in some cases. When the total amount of one or more elements selected from among Fe, Ni, Co, and Al is higher than the upper limit of the range, large amounts of these elements form a solid solution with silicon nitride, and the thermal conductivity of the silicon nitride-based sintered body may decrease by phonon scattering. Among these elements, the Al content is preferably 0.1 wt% or less.

The silicon nitride-based sintered body contains a group 4 element in a total amount of 0.30 to 3.0 wt%. Also, in the silicon nitride-based sintered body, at least a part of the group 4 element forms one or more compounds each containing at least one of nitrogen and carbon, and the sintered body contains the compound(s) in a total amount of 0.30 to 3.0 wt%. Hereinafter, the compound containing a group 4 element and at least one of nitrogen and carbon will be referred to as a "group 4 element compound".

When the group 4 element content falls within the above range, and the group 4 element compound content falls within the above range, both high thermal conductivity and high mechanical strength can be attained. Since the group 4 element does not form a solid solution with silicon nitride, a drop in thermal conductivity possibly caused by phonon scattering is not evoked. In addition, the group 4 element does not form a solid solution with a grain boundary phase formed via reaction between the rare earth element and silicon nitride. Thus, the group 4 element alone easily forms a compound, and residual pores are filled with the compound. As a result, the mechanical strength of the silicon nitride-based sintered body is enhanced. In addition, the group 4 element compound particles suppress propagation of cracking, thereby leading to high toughness. Notably, the "group 4 element compound" encompasses a compound containing only a group 4 element and nitrogen or carbon; a compound containing a group 4 element, nitrogen, and carbon; and such a compound forming a solid solution with another group 4 element or an anion (e.g., oxygen), so long as the intrinsic crystal structure is stable.

By virtue of the aforementioned characteristics, there can be yielded a silicon nitride-based sintered body having a further enhanced mechanical strength, while high thermal conductivity is maintained.

The grain particle size of grains of the group 4 element compound is preferably 8.0 µm or less. When the average grain size of the group 4 element compound grains falls within the above range, a silicon nitride sintered body having high mechanical strength can be yielded. When the average grain size is greater than the upper limit of the range, an origin of fracture is provided, and the compound is localized. In such a case, residual pores may increase, and a drop in mechanical strength may occur.

The average grain size of particles of the group 4 element compound may be determined through observation under a scanning electron microscope (SEM). In a specific procedure, five sites in a polished surface of the silicon nitride-based sintered body are selected at random, and a vision field (120 µm × 90 µm) of each site is observed at a magnification of 2,000. A circle-equivalent grain size is measured from the area of grains assumed to be formed of a group 4 element compound, and the thus-obtained measurements are averaged, to thereby determine the average grain size. In calculation of the average grains size, image analysis software such as Winroof may be employed. Notably, the group 4 element compound can be identified through X-ray fluorescence (XRF) and X-ray diffraction (XRD).

The number of intergranular linking of the group 4 element compound grains is preferably smaller than 3. When the number of linking is smaller than 3, difficulty is encountered in providing an origin of fracture, and a drop in mechanical strength can be prevented. Also, in the case where the group 4 element compound has electrical conductivity, intergranular linkage of grains decreases, whereby insulation property can be easily maintained. The number of intergranular linkage of grains of the group 4 element compound is a maximum value among those observed in the aforementioned five vision fields.

The group 4 element preferably contains one or more elements selected from Zr and Hf. In this case, more specific formulation of the group 4 element compound can be achieved. When the silicon nitride-based sintered body contains Zr, zirconium nitride (ZrN), zirconium carbide (ZrC), and zirconium carbide nitride (ZrCN) are easily formed as the group 4 element compound. When the silicon nitride-based sintered body contains Hf, hafnium nitride (HfN), hafnium carbide (HfC), and hafnium carbide nitride (HfCN) are easily formed as the group 4 element compound.

### [Configuration of silicon nitride-based heat radiation substrate]

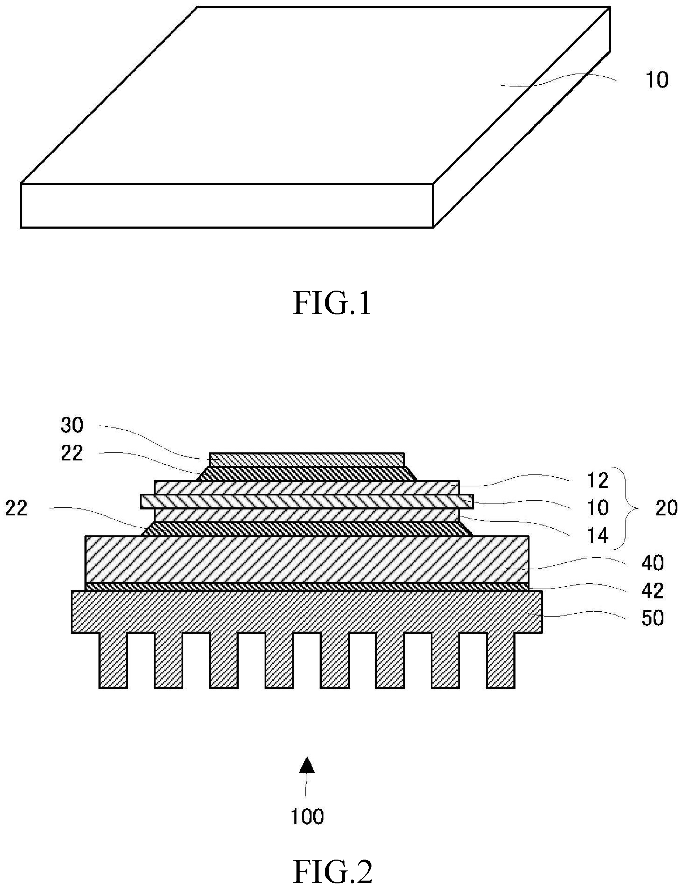

FIG. 1 is a schematic perspective view showing an example of a silicon nitride-based heat radiation substrate according to an embodiment of the present invention. A silicon nitride-based heat radiation substrate 10 according to the present invention is formed of the aforementioned silicon nitride-based sintered body. Thus, high mechanical strength can be achieved, while high thermal conductivity is maintained. As a result, occurrence of any failure in a circuit substrate employing the heat radiation substrate can be reduced. The silicon nitride-based heat radiation substrate 10 of the present invention can be suitably used as a heat radiation substrate of a circuit substrate for power devices. The silicon nitride-based heat radiation substrate 10 is shaped into, for example, a plate.

The silicon nitride-based heat radiation substrate 10 preferably has a flexural strength of 650 MPa or higher. In this case, breaking of the silicon nitride-based heat radiation substrate 10 can be suppressed.

The flexural strength can be measured through the following procedure. Specifically, in accordance with ISO 23242, a silicon nitride-based heat radiation substrate is processed to specific dimensions of (fixed thickness) × 12 × 25 mm, and flexural strength is measured with a span of 15 mm by a three-point bending method. ISO 23242 may be applied to a ceramic thin plate having a thickness of 0.2 mm to 1.0 mm.

Preferably, the silicon nitride-based heat radiation substrate 10 has a thermal conductivity of 85 W/mK or higher. In this case, the performance as a heat radiation substrate can be fully achieved.

Thermal conductivity may be calculated in the following manner. Firstly, a silicon nitride-based heat radiation substrate 10 is processed into pieces having dimensions of 0.32 mm × 17 mm × 17 mm. Thermal diffusivity of each piece is measured through a 2-dimensional method based on the laser flash method. Also, the density of the silicon nitride-based heat radiation substrate 10 is measured in accordance with a method according to JIS R1634. Specific heat is fixed at a constant value of 0.68 cm²/sec. From the thus-obtained thermal diffusivity and density, thermal conductivity can be calculated by an equation: (thermal conductivity)=(density)×(specific heat)×(thermal diffusivity).

Preferably, the silicon nitride-based heat radiation substrate 10 has a thickness in a direction perpendicular to its one main face of 220 µm or more and 690 µm or less. In this case, the mechanical strength and heat radiation performance of the silicon nitride-based heat radiation substrate 10 can be achieved in a well-balanced manner. When the thickness is less than the lower limit of the range, the mechanical strength of the substrate decreases in some cases, whereas the thickness is greater than the upper limit of the range, heat radiation performance decreases in some cases.

### [Configuration of power device]

FIG. 2 is a schematic cross-sectional view showing an example of a power device employing the silicon nitride-based heat radiation substrate according to an embodiment of the present invention. A power device 100 has a circuit substrate 20, a power semiconductor 30, a heat radiation plate 40, and a heat radiation member 50.

The circuit substrate 20 has a circuit layer 12 formed on one main face of the silicon nitride-based heat radiation substrate 10, and a conductor layer 14 formed on the face opposing to the one main face. The circuit layer 12 and the conductor layer 14 are preferably formed of a metal, more preferably a metal mainly containing copper. The circuit layer 12 and the conductor layer 14 are joined directly to the silicon nitride-based heat radiation substrate 10 or by the mediation of a joining material such as braze.

On the circuit layer 12 of the circuit substrate 20, a power semiconductor 30 is mounted. The power semiconductor 30 and the circuit layer 12 may be joined together by use of a solder 22 or the like. The power semiconductor 30 may be formed of, for example, a semiconductor which allows passage of large current for EVs and is easily heated to high temperature. Since the silicon nitride-based heat radiation substrate 10 of the present invention exhibits high mechanical strength while high thermal conductivity is maintained, generation of cracking or the like is prevented, even when large thermal stress is generated in the silicon nitride-based heat radiation substrate 10 due to the high temperature-induced difference in thermal expansion between the silicon nitride-based heat radiation substrate 10 and the joining metal.

To the lower face of the conductor layer 14 of the circuit substrate 20, a heat radiation plate 40 is joined. The heat radiation plate 40 and the conductor layer 14 may be bonded together by use of a solder 22 or the like. The face opposite to the face joined to the conductor layer 14 of the heat radiation plate 40 is in contact with a heat radiation member 50 via a grease 42. The heat radiation plate 40 is preferably formed of a metal, more preferably a metal mainly containing copper. The heat radiation member 50 is provided with heat radiation fins. The heat radiation member 50 is preferably formed of a metal, more preferably a metal mainly containing copper or aluminum.

### [Method of manufacturing silicon nitride-based sintered body and silicon nitride-based heat radiation substrate]

An example of a method of manufacturing the silicon nitride-based sintered body and the silicon nitride-based heat radiation substrate will be described. Firstly, essential members are selected from the powder raw materials of the silicon nitride-based sintered body, and weighed to attain the target composition. The powder raw materials of the silicon nitride-based sintered body may be an oxide, a carbonate salt, a hydroxide, a nitride, etc. of the elements contained in the silicon nitride-based sintered body. In addition to silicon nitride, examples of the powder raw material of the silicon nitride-based sintered body include magnesium carbonate, calcium carbonate, yttrium oxide, ytterbium oxide, erbium oxide, lanthanum oxide, and zirconium nitride.

Ethanol is added to the powder raw materials, and the mixture is wet-pulverized by means of a ball mill for, for example, 6 to 60 hours, to thereby yield a slurry. The slurry is dried by heating on a hot water bath or by means of a spray drier or the like, to thereby prepare a powder mixture.

Subsequently, the powder mixture is charged into a mold and shaped through monoaxial pressing at a pressure of, for example, 30 MPa, to thereby yield a molded body of desired shape. Thereafter, the molded body is subjected to a CIP treatment (cold isostatic pressing) at a pressure, for example, 150 MPa, to thereby yield a compact. The thus-obtained compact (i.e., a CIP press body) is subjected to, for example, the following process including placing the compact in a silicon carbide mold having an inside coating of BN and maintaining the compact at a maximum temperature of 1,800°C to 1,900°C in a silicon carbide mold under nitrogen at 9 atm for 5 to 20 hours, for firing, to thereby yield a silicon nitride-based sintered body.

In the case where the silicon nitride-based sintered body is employed as a silicon nitride-based heat radiation substrate, the sintered body is processed so as to provide a predetermined outer shape having a specific thickness. Examples of the processing which may be employed include cutting, grinding, and blasting.

Through the aforementioned manufacturing method, there can be produced a silicon nitride-based sintered body or a silicon nitride-based heat radiation substrate which exhibits high mechanical strength, while high thermal conductivity is maintained.

### [Examples and Comparative Examples]

### (Sample 1)

Magnesium carbonate powder (average particle size: 2.5 µm) and yttrium oxide powder (average particle size: 1.0 µm) were weighed in amounts of 3.2 wt% and 3.0 wt%, respectively, with respect to 100 wt% of silicon nitride powder (average particle size: 1.4 µm). Next, the weighed powder raw materials were subjected to ball milling, to thereby prepare a mixed slurry. In ball milling, the powder raw materials and ethanol were put into a resin pot, and the mixture was pulverized by means of YSZ (i.e., Y₂O₃-partially stabilized zirconia) balls at 60 rpm for 24 hours. The thus-obtained mixed slurry was dried on a hot water bath, to thereby yield a powder mixture.

The obtained powder mixture was mono-axially pressed and subjected to CIP, to thereby form a compact. In a specific procedure, firstly, the powder mixture was charged into a specialized mold and then, conducting preliminary molding through mono-axial pressing at 30 MPa. Subsequently, the preliminary compact was put into a specialized bag, and CIP molding was conducted at 150 MPa while the bag was evacuated.

The thus-obtained compact was fired. In firing, the compact was maintained in an atmosphere of nitrogen (gas pressure: 9 atm) for 5 hours at a maximum temperature of 1,900°C. The mold employed in firing was a silicon carbide mold having an inside coating of BN. Thus, a silicon nitride-based sintered body of sample 1 was yielded.

### (Sample 2)

A silicon nitride-based sintered body of sample 2 was produced under the same conditions as those of sample 1, except that the amount of magnesium carbonate powder was 4.0 wt%.

### (Sample 3)

A silicon nitride-based sintered body of sample 3 was produced under the same conditions as those of sample 1, except that the amount of magnesium carbonate powder was 5.0 wt%.

### (Sample 4)

A silicon nitride-based sintered body of sample 4 was produced under the same conditions as those of sample 1, except that the amount of magnesium carbonate powder added was 8.0 wt%.

### (Sample 5)

A silicon nitride-based sintered body of sample 5 was produced under the same conditions as those of sample 3, except that the amount of yttrium oxide powder was 6.0 wt%.

### (Sample 6)

A silicon nitride-based sintered body of sample 6 was produced under the same conditions as those of sample 3, except that the amount of yttrium oxide powder was 8.5 wt%.

### (Sample 7)

A silicon nitride-based sintered body of sample 7 was produced under the same conditions as those of sample 6, except that yttrium oxide powder was changed to ytterbium oxide powder (average particle size: 1.2 µm).

### (Sample 8)

A silicon nitride-based sintered body of sample 8 was produced under the same conditions as those of sample 6, except that yttrium oxide powder was changed to erbium oxide powder (average particle size: 1.4 µm).

### (Sample 9)

A silicon nitride-based sintered body of sample 9 was produced under the same conditions as those of sample 6, except that yttrium oxide powder was changed to lanthanum oxide powder (average particle size: 1.0 µm).

### (Sample 10)

A silicon nitride-based sintered body of sample 10 was produced under the same conditions as those of sample 5, except that calcium carbonate powder (average particle size: 2.5 µm) was further added in an amount of 5.0 wt%.

### (Sample 11)

A silicon nitride-based sintered body of sample 11 was produced under the same conditions as those of sample 5, except that the maximum temperature in firing was 1,850°C.

### (Sample 12)

A silicon nitride-based sintered body of sample 12 was produced under the same conditions as those of sample 5, except that the maximum temperature in firing was 1,800°C.

### (Sample 13)

A silicon nitride-based sintered body of sample 13 was produced under the same conditions as those of sample 3, except that the amount of yttrium oxide powder was 1.0 wt%.

### (Sample 14)

A silicon nitride-based sintered body of sample 14 was produced under the same conditions as those of sample 3, except that the amount of yttrium oxide powder was 9.5 wt%.

### (Sample 15)

A silicon nitride-based sintered body of sample 15 was produced under the same conditions as those of sample 5, except that the amount of magnesium carbonate powder was 1.5 wt%.

### (Sample 16)

A silicon nitride-based sintered body of sample 16 was produced under the same conditions as those of sample 5, except that the amount of magnesium carbonate powder was 11.5 wt%.

### (Sample 17)

A silicon nitride-based sintered body of sample 17 was produced under the same conditions as those of sample 5, except that the silicon nitride powder was changed to a high-purity silicon nitride powder (average particle size: 0.9 µm).

### (Sample 18)

A silicon nitride-based sintered body of sample 18 was produced under the same conditions as those of sample 5, except that the silicon nitride powder was changed to a low-purity silicon nitride powder (average particle size: 1.2 µm).

### (Sample 19)

A silicon nitride-based sintered body of sample 19 was produced under the same conditions as those of sample 5, except that the time for mixing to form a mixed slurry was 6 hours.

### (Sample 20)

A silicon nitride-based sintered body of sample 20 was produced under the same conditions as those of sample 5, except that the time for mixing to form a mixed slurry was 60 hours.

### (Sample 21)

A silicon nitride-based sintered body of sample 21 was produced under the same conditions as those of sample 5, except that the balls employed in preparing a mixed slurry were changed from YSZ balls to silicon nitride balls.

### (Sample 22)

A silicon nitride-based sintered body of sample 22 was produced under the same conditions as those of sample 5, except that the time for maintaining the compact at the maximum temperature in firing was 20 hours.

### (Sample 23)

A silicon nitride-based sintered body of sample 23 was produced under the same conditions as those of sample 5, except that zirconium nitride powder (average particle size: 1.6 µm) was further added in an amount of 1.0 wt%.

### (Sample 24)

A silicon nitride-based sintered body of sample 24 was produced under the same conditions as those of sample 3, except that the compact was fired in a silicon carbide mold with a BN inner coating to which carbon powder had been added.

### [Measurements]

A sintered body produced as each sample was assessed through the following measurement procedures and the like.

### (Measurement of density)

The density of a sintered body of each sample was measured in accordance with JIS R1634.

### (Determination of element amount)

Through X-ray fluorescent (XRF) analysis, the species and relative amounts of the elements forming each sintered body sample were determined.

### (Identification of constitutional phase)

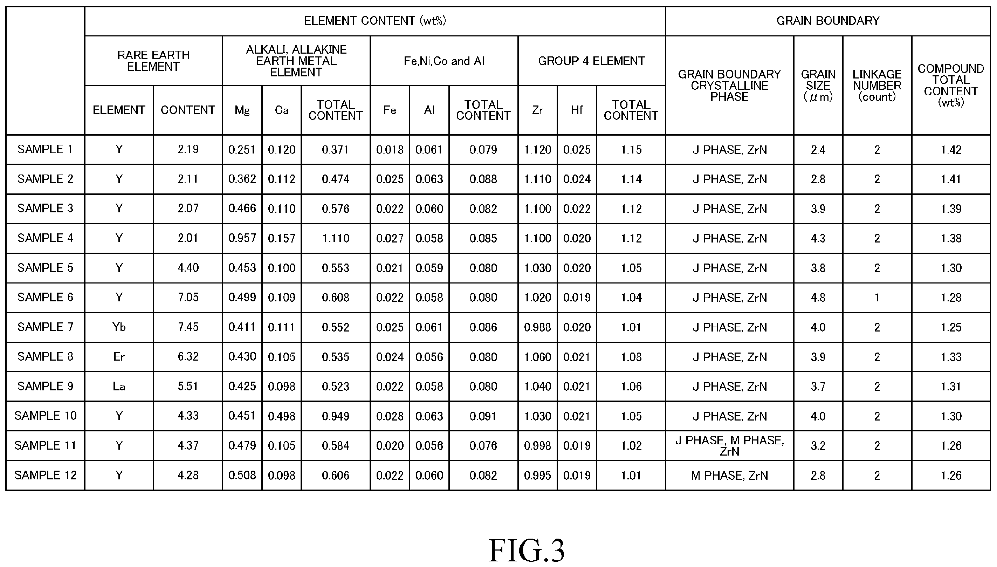

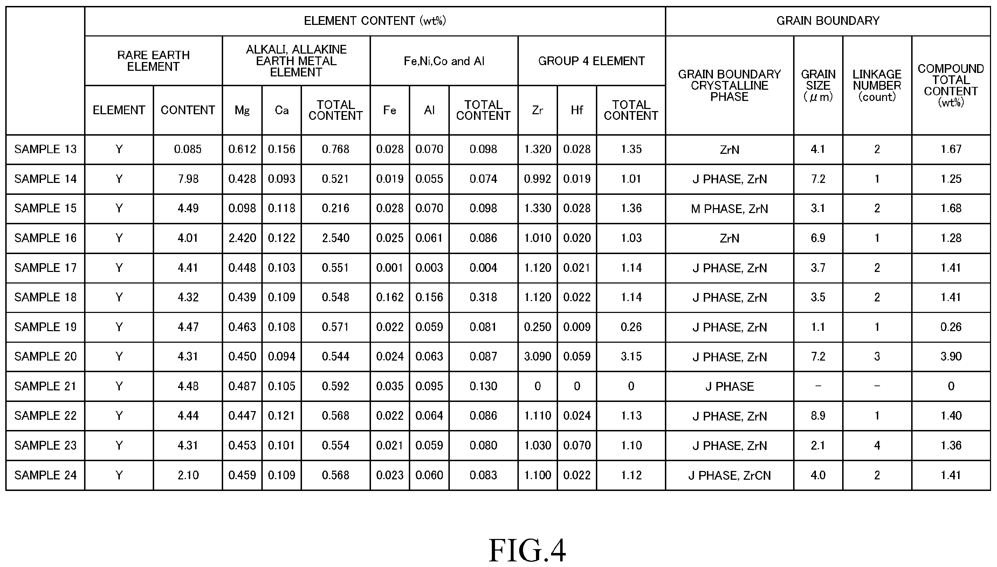

The constitutional phases of each sintered body sample were identified through XRD analysis. From the results of XRF and XRD, the amount of the compound containing the group 4 element and at least one of nitrogen and carbon (i.e., a group 4 element compound) was calculated. However, in the tables of FIGs. 3 and 4, only components identified as crystalline components are shown, and information on the presence of amorphous components is omitted. In the column of "grain boundary crystal phase" in each of Figs. 3 and 4, phase J represents Y₄Si₂O₇N₂, and phase M represents Y₂Si₃O₃N₄.

### (Measurement of grain size)

The average particle size of the group 4 element compound was determined through observation under a SEM. In a specific procedure, five sites in a polished surface of silicon nitride-based sintered body were selected at random, and a vision field (120 µm × 90 µm) of each site was observed at a magnification of 2,000. A circle-equivalent grains size was measured from the area of grains assumed to be formed of a group 4 element compound, and the thus-obtained measurements were averaged, to thereby determine the average grain size.

### (Calculation of thermal conductivity)

A sintered body of each sample was processed into pieces having dimensions of 0.32 mm × 17 mm × 17 mm. Thermal diffusivity of each piece was measured through a 2-dimensional laser flash method. A fixed specific heat value of 0.68 cm²/sec was employed. From the thermal diffusivity obtained through the 2-dimensional method and density, thermal conductivity was calculated by an equation: (thermal conductivity)=(density)×(specific heat)×(thermal diffusivity).

### (Measurement of flexural strength)

In accordance with ISO 23242, a sintered body of each sample was processed to dimensions of 0.32 (thickness) × 12 × 25 mm, and the flexural strength was measured with a span of 15 mm by a three-point bending method.

### (Measurement of fracture toughness)

In accordance with JIS R1607, fracture toughness of a mirror-polished measurement surface was calculated through the IF method. Calculation was conducted by the Miyoshi's equation.

### (Results)

FIGs. 3 and 4 are tables showing the element content and characteristics of the grain boundary phase of each sample. Notably, Fe, Ni, Co, and Al present in each sample originate from the raw materials or an apparatus employed in production steps. Also, in the case of each sample (except for samples 21 and 23), the group 4 element present in the group 4 element or the group 4 element compound originates from balls made of YSZ employed in production steps.

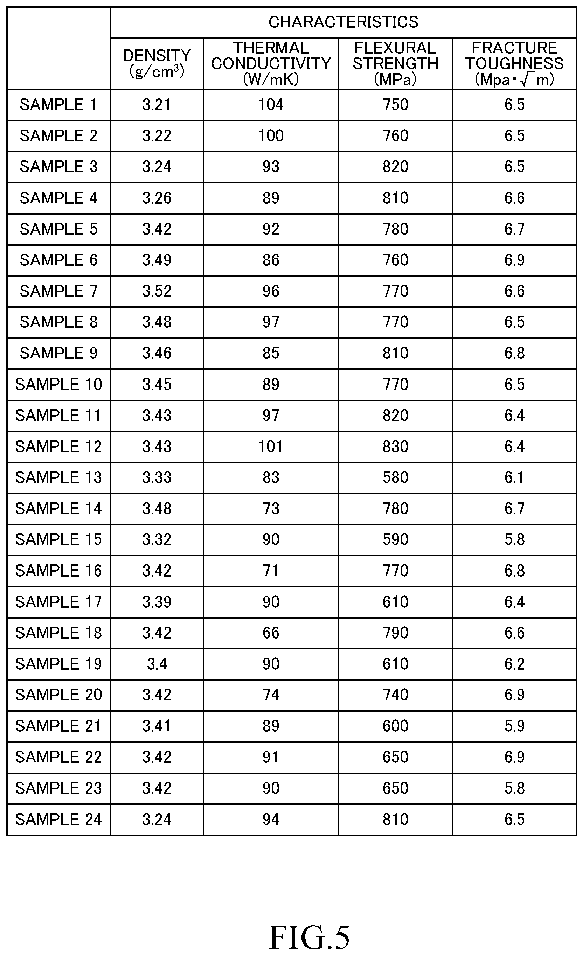

FIG. 5 is a table showing properties of each sample. Samples 1 to 12, and samples 22 to 24 were all found to exhibit a thermal conductivity of 85 W/mK or higher and a flexural strength of 650 MPa or higher, indicating both high thermal conductivity and flexural strength.

Sample 13 exhibited a low flexural strength. A conceivable reason for this is an excessively low rare earth element content. Sample 14 exhibited a low thermal conductivity. A conceivable reason for this is an excessive rare earth element content.

Sample 15 exhibited a low flexural strength. A conceivable reason for this is an excessively low alkali metal element content and alkaline earth metal element content. Sample 16 exhibited a low thermal conductivity. A conceivable reason for this is an excessive alkali metal element content and alkaline earth metal element content.

Sample 17 exhibited a low flexural strength. A conceivable reason for this is an excessively low total amount of Fe, Ni, Co, and Al. Sample 18 exhibited a low thermal conductivity. A conceivable reason for this is an excessive total amount of Fe, Ni, Co, and Al. Since sample 17 was prepared by use of a high-purity silicon nitride powder, the total amount of Fe, Ni, Co, and Al was reduced. As a result, it has been found that difficulty is encountered in controlling to achieve, for example, the composition of the present invention by simply enhancing the purity of raw materials, although the raw materials contain unavoidable impurities.

Sample 19 exhibited a low flexural strength. A conceivable reason for this is an excessively low group 4 element content or group 4 element compound content. Sample 20 exhibited a low thermal conductivity. A conceivable reason for this is an excessive group 4 element content or group 4 element compound content.

Sample 21 exhibited a low flexural strength. A conceivable reason for this is the absence of a group 4 element or a group 4 element compound, for use of balls made of silicon nitride and no external addition of a group 4 element compound.

Sample 22 exhibited a flexural strength falling within an acceptable range, although the measurements thereof were relatively low. A conceivable reason for this is the grain size of the group 4 element compound (ZrN) in excess of 8 µm.

Sample 23 exhibited a flexural strength falling within an acceptable range, although the measurements thereof were relatively low. A conceivable reason for this is linkage of 3 or more crystal grains of the group 4 element compound (ZrN).

Sample 24 exhibited both high thermal conductivity and flexural strength, although the identified group 4 element compound was ZrCN containing a group 4 element, nitrogen, and carbon. As a result, a group 4 element compound not containing only a group 4 element and nitrogen is not essential and causing no problem. The case in which the group 4 element compound is a compound containing a group 4 element and carbon could be assessed in a similar way.

The above-described test results have revealed that the silicon nitride-based sintered body and the silicon nitride-based heat radiation substrate of the present invention can provide higher mechanical strength, while high thermal conductivity is maintained.

Needless to say, the present invention is not limited to the above-described embodiments and encompasses various modifications and equivalents included in the idea and scope of the present invention. In addition, the structures, shapes, numbers, positions, sizes, etc. of the constituent elements shown in the drawings are for the convenience of description and may be changed as appropriate.

### DESCRIPTION OF REFERENCE NUMERALS

- 10:: silicon nitride-based heat radiation substrate
- 12:: circuit layer
- 14:: conductor layer
- 20:: circuit substrate
- 22:: solder
- 30:: power semiconductor
- 40:: heat radiation plate
- 42:: grease
- 50:: heat radiation member
- 100:: power device

## Claims

1. A silicon nitride-based sintered body mainly comprising silicon nitride-based grains and a grain boundary phase surrounding the silicon nitride-based grains, wherein,
the sintered body at least contains a rare earth element in a total amount of 1.0 to 7.5 wt%, an alkali metal element and an alkaline earth metal element in a total amount of 0.25 to 2.0 wt%, one or more elements selected from among Fe, Ni, Co, and Al in a total amount of 0.010 to 0.30 wt%, and a group 4 element in a total amount of 0.30 to 3.0 wt%;
at least a part of the group 4 element forms one or more compounds each containing at least one of nitrogen and carbon, and the sintered body contains the compounds in a total amount of 0.30 to 3.0 wt%.

2. The silicon nitride-based sintered body according to claim 1, wherein the compound or compounds have an average grain size of 8.0 µm or less.

3. The silicon nitride-based sintered body according to claim 1 or 2, wherein the number of grains linking to one another in the compound or compounds is smaller than 3.

4. The silicon nitride-based sintered body according to claim 1 or 2, wherein the group 4 element includes one or more elements selected from Zr and Hf.

5. A silicon nitride-based heat radiation substrate **characterized by** being formed of a silicon nitride-based sintered body according to claim 1 or 2.

6. The silicon nitride-based heat radiation substrate according to claim 5, wherein a flexural strength is 650 MPa or higher.

7. The silicon nitride-based heat radiation substrate according to claim 5, wherein a thermal conductivity is 85 W/mK or higher.

8. The silicon nitride-based heat radiation substrate according to claim 5, wherein a thickness in a direction perpendicular to its one main face is 220 µm or more and 690 µm or less.
